# EUROPÄISCHE PATENTSCHRIFT

(11) **EP 0 947 000 B1**
(45) Veröffentlichungstag und Bekanntmachung des Hinweises auf die Patenterteilung: **20.04.2005**
(21) Anmeldenummer: 97951854.5
(22) Anmeldetag: 12.12.1997
(51) Int. Cl.: H01L 41/04

(54) **VERFAHREN UND VORRICHTUNG ZUM ANSTEUERN WENIGSTENS EINES KAPAZITIVEN STELLGLIEDES**
METHOD AND DEVICE FOR CONTROLLING AT LEAST ONE CAPACITIVE ACTUATOR
PROCEDE ET DISPOSITIF POUR COMMANDER AU MOINS UN ACTIONNEUR CAPACITIF

(30) Priorität: 18.12.1996 DE 19652809
(43) Veröffentlichungstag der Anmeldung: 06.10.1999
(73) Patentinhaber: SIEMENS AKTIENGESELLSCHAFT, 80333 München (DE)
(72) Erfinder: HOFFMANN, Christian, D-93057 Regensburg (DE); FREUDENBERG, Hellmut, D-93080 Pentling (DE); GERKEN, Hartmut, D-93152 Nittendorf (DE); HECKER, Martin, D-93336 Laimerstadt (DE); PIRKL, Richard, D-93053 Regensburg (DE)
(86) Internationale Anmeldenummer: PCT/DE1997/002905
(87) Internationale Veröffentlichungsnummer: WO 1998/027601

(56) Entgegenhaltungen:
- US-A- 5 130 598
- PATENT ABSTRACTS OF JAPAN vol. 011, no. 127 (E-501), 21.April 1987 & JP 61 271881 A (NIPPON SOKEN INC), 2.Dezember 1986,

## Beschreibung

Die Erfindung betrifft ein Verfahren und eine Vorrichtung zum Ansteuern wenigstens eines kapazitiven Stellgliedes, insbesondere eines piezoelektrisch betriebenen Kraftstoffeinspritzventils einer Brennkraftmaschine.

Piezo-Stellglieder bestehen aus einer Vielzahl piezokeramischer Schichten und bilden einen sog. "Stack", der bei Anlegen einer Spannung seine Abmessungen, insbesondere seine Länge s um einen Hub ds verändert, oder bei mechanischem Druck oder Zug eine elektrische Spannung erzeugt.

Aus DE 41 22 984 A1 ist eine Ansteuereinrichtung für ein piezoelektrisches Element bekannt, bei welcher die Ansteuerung des piezoelektrischen Elements über entsprechende elektronische Schalter mit vorgegebenen Lade- und Entladezeiten erfolgt.

In der älteren deutschen Patentanmeldung 19632872.1 wurde bereits ein Verfahren zum Ansteuern eines kapazitiven Stellgliedes vorgeschlagen, nach welchem das Stellglied mit vorgegebener Ladespannung solange geladen wird, bis die während des Ansteuervorgangs gemessene Spannung am Stellglied einen vorgegebenen Wert erreicht.

Es ist Aufgabe der Erfindung, ein Verfahren zur Spannungsregelung beim Ansteuern wenigstens eines kapazitiven Stellgliedes anzugeben, auch wenn beim Ansteuern ein Abbrechen des Ladevorgangs nicht möglich ist. Aufgabe der Erfindung ist es auch, eine Vorrichtung zur Durchführung dieses Verfahrens zu schaffen.

Diese Aufgabe wird erfindungsgemäß durch die Merkmale des Patentanspruchs 1 gelöst.

Ein Ausführungsbeispiel nach der Erfindung ist im folgenden unter Bezugnahme auf die schematische Zeichnung näher erläutert.

Es zeigen:
- Figur 1: ein Diagramm der Stellgliedspannung Up über der Ladespannung Uc,
- Figur 2: ein Schaltbild einer Vorrichtung zum Ansteuern meh rerer Stellglieder, und
- Figur 3: ein Flußdiagramm, betreffend die Arbeitsweise der Schaltung nach Figur 2.

Die Erfindung geht von der Überlegung aus, daß es sich in der Regel um temperaturbedingte Veränderungen handelt, die eine gegenüber dem zeitlichen Abstand aufeinanderfolgender Stellgliedbetätigungen bei einer Brennkraftmaschine sehr große Zeitkonstante aufweisen, oder um Exemplartoleranzen, die sich nicht ändern. Es ist deshalb nicht erforderlich, die Steuerung oder Regelung der Aufladung im Regelzyklus (Ansteuervorgang) selbst durchzuführen, sondern es genügt vollkommen, eine Abweichung in einem Ansteuervorgang festzustellen und diese dann im darauffolgenden Ansteuervorgang zu korrigieren.

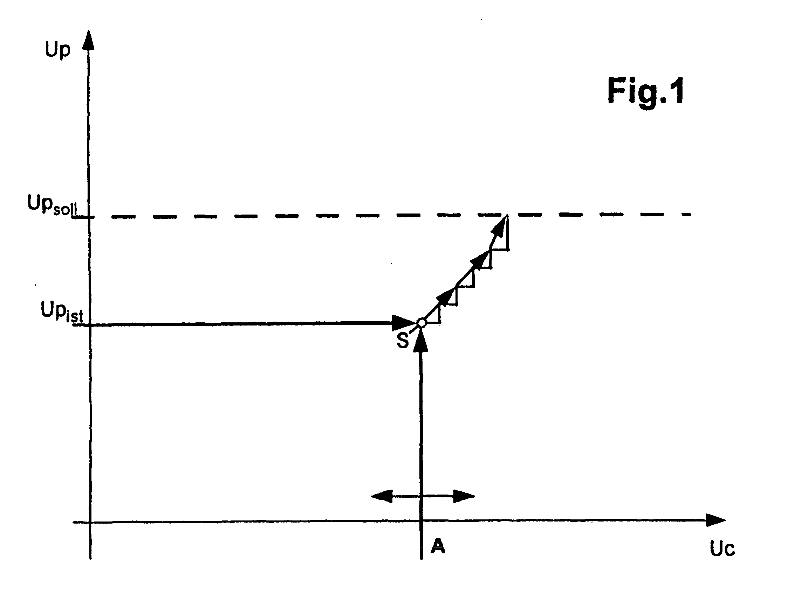

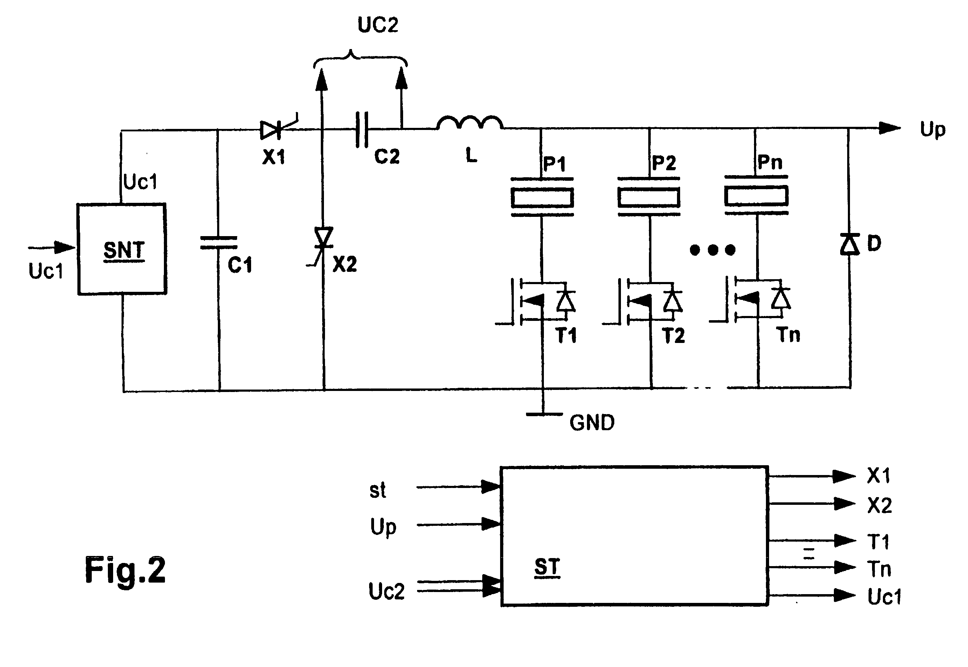

Figur 1 zeigt ein Diagramm über den Zusammenhang zwischen Ladespannung Uc und Stellgliedspannung Up, wobei ein vorgegebener Stellglied-Sollwert Upₛₒₗₗ strichliert eingezeichnet ist. Anhand dieses Diagramms und der in Figur 2 dargestellten Schaltung einer Ansteuervorrichtung für mehrere kapazitive Stellglieder wird das erfindungsgemäße Verfahren nachstehend beschrieben.

Die Ansteuerung von weiter nicht dargestellten n Kraftstoffeinspritzventilen einer Brennkraftmaschine über piezoelektrische Stellglieder P1 bis Pn erfolgt mittels einer Steuerschaltung ST, die Teil eines weiter nicht dargestellten mikroprozessor-gesteuerten Motorsteuergerätes ist.

In Figur 2 ist zwischen dem Pluspol Uc1 und dem Minuspol GND einer steuerbaren Spannungsquelle SNT, vorzugsweise eines

Schaltnetzteils, ein Ladekondensator C1 angeschlossen, welcher als Ausgangskondensator des Schaltnetzteils SNT betrachtet werden kann und auf dessen Ausgangsspannung Uc1 aufgeladen ist. Parallel zum Ladekondensator C1 ist eine Reihenschaltung aus einem mit dem Pluspol Uc1 verbundenen, von ihm weg stromdurchlässigen Ladeschalter X1 und einem mit dem Minuspol GND verbundenen, zu ihm hin stromdurchlässigen Entladeschalter X2 angeordnet.

Wenn von Schaltern X1 und X2 die Rede ist, handelt es sich um elektronische, nur in einer Richtung stromdurchlässige, aus wenigstens einem Halbleiterelement bestehende Schalter, vorzugsweise Thyristorschalter, die von der Steuerschaltung leitend gesteuert werden.

Zwischen dem Verbindungspunkt von Ladeschalter X1 und Entladeschalter X2 und dem Masseanschluß GND liegt eine Reihenschaltung aus einem Umladekondensator C2, einer Umschwingspule L, einem ersten Stellglied P1 und einem ersten, gesteuerten Power-MOSFET-Schalter T1.

Für jedes weitere Stellglied ist eine Reihenschaltung aus dem Stellglied P2 bis Pn und einem weiteren Power-MOSFET-Schalter T2 bis Tn der Reihenschaltung aus dem ersten Stellglied P1 und dem ersten Power-MOSFET-Schalter T1 parallel geschaltet.

Parallel zu den Reihenschaltungen aus Stellglied und Power-MOSFET-Schalter ist eine vom Masseanschluß GND weg zur Umschwingspule L hin stromdurchlässige Diode D angeordnet. Power-MOSFET-Schalter enthalten üblicherweise Inversdioden, deren Funktion, wie weiter unten näher erläutert, beim Betrieb der erfindungsgemäßen Vorrichtung benutzt wird.

Die Schalter X1, X2 und T1 bis Tn werden von der Steuerschaltung ST entsprechend einem dem erfindungsgemäßen Verfahren zugeordneten Programm, abhängig von Steuersignalen st des Motorsteuergerätes, von der Stellgliedspannung Up und von der nach dem Entladen des Stellgliedes am Umladekondensator C2 anliegenden Spannung Uc2 gesteuert.

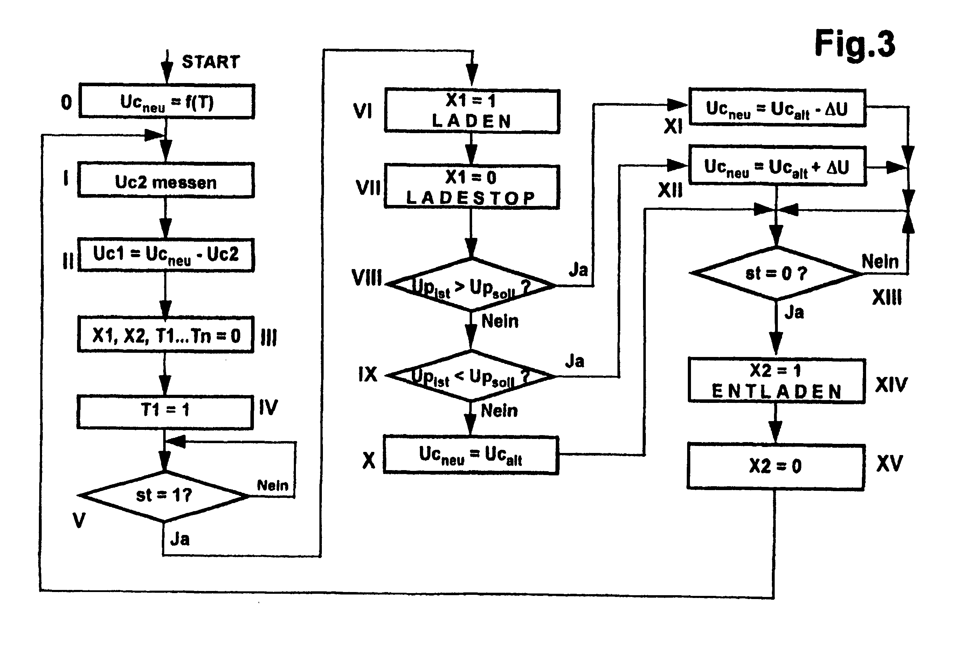

Das erfindungsgemäße Verfahren zum aufeinanderfolgenden Ansteuern mehrerer kapazitiver Stellglieder wird nachstehend anhand des in Figur 3 dargestellten Flußdiagramms unter Zugrundelegung der in Figur 2 gezeigten Schaltung für ein Stellglied P1 näher erläutert. Die einzelnen Kästchen, den jeweiligen Verfahrenszuständen zugeordnet, sind mit römischen Zahlen gekennzeichnet.

Die Ladespannung Uc (= Uc1 + Uc2) wird beim ersten Ansteuervorgang bei Inbetriebnahme des Fahrzeuges als Anfangswert A vorgegeben (Zustand 0). Dieser Wert der Ladespannung Uc kann eine Funktion der Motortemperatur sein: Uc = f(T), da sich die Stellgliedkapazität im Motortemperaturbereich um den Faktor 2 ändern kann.

Beim ersten Ansteuervorgang ist der Umladekondensator C2 entladen, Uc2 = 0V (Zustand I). Dementsprechend wird die Ausgangsspannung der steuerbaren Spannungsquelle SNT auf die Spannung Uc1 = Uc (Anfangswert A) eingestellt (Zustand II).

Bei einem Zustand III, in welchem die Umschwingspule L stromlos ist, alle Schalter X1, X2 und T1 bis Tn nichtleitend (hochohmig) und alle Stellglieder P1 bis Pn entladen sind, soll das Stellglied P1 betätigt werden, um über das zugeordnete Einspritzventil Kraftstoff in den Zylinder 1 einzuspritzen. Zunächst wählt die Steuerschaltung das entsprechende Stellglied aus - hier P1 - (Zustand IV), indem sie den ihm zugeordneten Power-MOSFET-Schalter T1 leitend steuert. T1 kann über einen Kurbelwellenwinkel KW = 720°KW/Z (Z = Zahl der Zylinder) leitend (niederohmig) bleiben, das sind beispielsweise bei Vierzylindermotoren 180°KW und bei Sechszylindermotoren 120°KW.

Beim Einspritzbeginn, der durch den Beginn eines Steuersignals st = 1 (Zustand V) vorgegeben ist, wird von der Steuerschaltung ST der Ladeschalter X1 gezündet (Zustand VI). Dadurch entlädt sich die an der Reihenschaltung aus C1 + C2 liegende Ladespannung Uc während einer kompletten Sinushalbschwingung über die Umschwingspule L in das Stellglied P1 und dieses öffnet das nicht dargestellte Einspritzventil. Die Spannungsquelle - das Schaltnetzteil SNT - bleibt mit dem Ladekondensator C1 verbunden, so daß auch sie Energie in den Schwingkreis einspeist.

Nach dem Umschwingen verlischt der Ladeschalter X1 von selbst (Zustand VII), das Stellglied P1 ist auf eine Stellgliedspannung Upᵢₛₜ geladen. In Figur 1 ergibt sich ein Schnittpunkt S von Ladespannung Uc und Stellgliedspannung Upᵢₛₜ.

Der nach dem Ende des Ladevorgangs am Stellglied P1 sich einstellende Istwert Upᵢₛₜ der Stellgliedspannung Up wird der Steuerschaltung ST mitgeteilt, welche sie mit einem vorgegebenen, in Figur 1 strichliert eingezeichneten Sollwert Upₛₒₗₗ vergleicht (Zustände VIII und IX).

Ist der Istwert Upᵢₛₜ größer als der Sollwert Upₛₒₗₗ (Zustand VIII), so wird für den nächsten Ansteuervorgang des Stellgliedes P1 ein neuer Wert für die Ladespannung Uc bestimmt: Ucₙₑᵤ = Ucₐₗₜ - DU (Zustand XI). Daraufhin wird sich dann im nächsten Ansteuervorgang eine niedrigere Stellgliedspannung Upᵢₛₜ einstellen. Ist der Istwert Upᵢₛₜ aber kleiner als der Sollwert Upₛₒₗₗ (Zustand IX), so wird für den nächsten Ansteuervorgang ein größerer, neuer Wert für die Ladespannung Uc bestimmt: Uc_{neu.} = Ucₐₗₜ + DU (Zustand XII). Ist der Wert Upᵢₛₜ gleich dem Sollwert Upₛₒₗₗ (Zustand X), so bleibt beim nächsten Ansteuervcrgang des Stellgliedes P1 die Ladespannung Uc unverändert. Der Annäherungsvorgang an den Sollwert kann, wie beschrieben und in Figur 1 durch Pfeile angedeutet, inkrementell durch vorgegebene Schritte DU, oder nach jedem beliebigen Annäherungsverfahren, erfolgen.

Zum Entladen des Stellgliedes P1 am Ende eines Steuersignals st (Zustand XIII) wird der Entladeschalter X2 gezündet (Zustand XIV). Der Entladestromkreis schließt sich über die Inversdiode des Power-MOSFET-Schalters T1. Die im Stellglied gespeicherte Energie schwingt über die Umschwingspule L in den Umladekondensator C2 zurück; die in ihm gespeicherte Energie kann für den folgenden Ansteuervorgang genutzt werden.

Sobald das Stellglied auf die Schwellspannung der dem "aktiven" Kanal parallel liegenden Diode D entladen ist, setzt sich der noch fließende Strom über diese Diode fort, wodurch ein Aufladen des Stellgliedes auf eine negative Spannung verhindert wird. Anschließend verlischt der Entladeschalter X2 von selbst (Zustsand XV).

Für den nächsten Ansteuervorgang des Stellgliedes P1 muß der Ladekondensator C1 auf eine Spannung Uc1 = Uc - Uc2 aufgeladen werden, wozu Uc2 gemessen wird (Zustand I). Damit kann Uc1 = Uc - Uc2 ermittelt werden (Zustand II). Auf diesen Wert wird das Schaltnetzteil SNT für den nächsten Ansteuervorgang des Stellgliedes P1 eingestellt und damit der Ladekondensator C1 auf Uc1 geladen. Mit den in diesem Ansteuervorgang ermittelten Werten wird der nächste Ansteuervorgang, ab Zustand III, durchgeführt. Die Ansteuervorgänge für die anderen Stellglieder P2 bis Pn entsprechen dem beschriebenen Verfahren für das Stellglied P1.

## Patentansprüche

1. Verfahren zum Ansteuern wenigstens eines kapazitiven Stellgliedes (P), insbesondere eines piezoelektrisch betriebenen Kraftstoffeinspritzventils einer Brennkraftmaschine,
- bei welchem am Beginn eines Ansteuervorgangs das Stellglied (P1 bis Pn) über eine Umschwingspule (L) aus einer Reihenschaltung eines Ladekondensators (C1) und eines Umladekondensators (C2) mit einer vorgebbaren Ladespannung (Uc = Uc1 + Uc2) geladen wird und am Ende des Ansteuervorgangs in den Umladekondensator (C2) wieder entladen wird,
- bei welchem die mit der Ladespannung (Uc) am Stellglied (P) erreichte Stellgliedspannung (Upᵢₛₜ) mit einer vorgegebenen Sollwertspannung (Upₛₒₗₗ) verglichen wird,
- bei welchem die Ladespannung (Ucₙₑᵤ) für den nächsten Ansteuervorgang abhängig von der Differenz (Upₛₒₗₗ - Upᵢₛₜ) von Sollwert (Upₛₒₗₗ) und Istwert (Upᵢₛₜ) bestimmt wird, und
- bei welchem der Ladekondensator (C1) für den nächsten Ansteuervorgang auf eine der Differenz (Ucₙₑᵤ - Uc2) zwischen dieser bestimmten Ladespannung (Ucₙₑᵤ) und der momentan am Umladekondensator (C2) anliegenden Spannung (Uc2) entsprechende Spannung (Ucl = Ucₙₑᵤ - Uc2) aufgeladen wird.

2. Verfahren nach Anspruch 1, **dadurch gekennzeichnet, daß** bei Betriebsbeginn für den ersten Ansteuervorgang jedes Stellgliedes (P1 bis Pn) ein Wert für die Ladespannung (Ucₙₑᵤ) vorgegeben wird.

3. Verfahren nach Anspruch 2, **dadurch gekennzeichnet, daß** der vorgegebene Wert (Ucₙₑᵤ) für die Ladespannung (Uc) von der Motortemperatur (T) abhängig ist.

4. Vorrichtung zur Durchführung des Verfahrens nach einem der vorhergehenden Ansprüche, **dadurch gekennzeichnet,**
**daß** zwischen demPluspol (Uc1) und dem Minuspol (GND) einer von einer Steuerschaltung (ST) steuerbaren Spannungsquelle (SNT) ein Ladekondensator (C1) angeordnet ist,
**daß** parallel zum Ladekondensator (C1) eine Reihenschaltung aus einem mit dem Pluspol (Uc1) verbundenen, von ihm weg stromdurchlässigen Ladeschalter (X1) und einem mit dem Minuspol (GND) verbundenen, zu ihm hin stromdurchlässigen Entladeschalter (X2) angeordnet ist,
**daß** zwischen dem Verbindungspunkt von Ladeschalter (X1) und Entladeschalter (X2) und dem Masseanschluß (GND) eine Reihenschaltung aus einem mit dem Ladeschalter (X1) verbundenen Umladekondensator (C2), einer Umschwingspule (L), einem ersten Stellglied (P1) und einem ersten, gesteuerten Power-MOSFET-Schalter(T1) angeordnet ist,
**daß** für jedes weitere Stellglied eine Reihenschaltung aus diesem Stellglied (P2 bis Pn) und einem weiteren Power-MOSFET-Schalter (T2 bis Tn) der Reihenschaltung des ersten Stellgliedes (P1) und des ersten Power-MOSFET-Schalters (T1) parallel geschaltet ist, und
**daß** parallel zur Reihenschaltung aus erstem Stellglied (P1) und Power-MOSFET-Schalter (T1) eine vom Masseanschluß (GND) zur Umschwingspule (L) hin stromdurchlässigen Diode (D) angeordnet ist.

5. Vorrichtung nach Anspruch 4, **dadurch gekennzeichnet, daß** die von der Steuerschaltung (ST) steuerbare Spannungsquelle (SNT) ein Schaltnetzteil ist.

6. Vorrichtung nach Anspruch 4, **dadurch gekennzeichnet,**
**daß** die Steuerschaltung (ST) ein Teil eines mikroprozessorgesteuerten Motorsteuergerätes ist, daß der Steuerschaltung (ST) als Eingangsgrößen Steuersignale (st) zum Ansteuern der Stellglieder, die am jeweils angesteuerten Stellglied (P1 bis Pn) anliegende Stellgliedspannung (Upᵢₛₜ) und die am Umladekondensator (C2) anliegende Spannung (Uc2) zugeführt werden, und welche den Ladeschalter (X1), den Entladeschalter (X2) und die Power-MOSFET-Schalter(T1 bis Tn) gemäß dem Verfahrensablauf nach Figur 3 steuert.

7. Vorrichtung nach Anspruch 4, **dadurch gekennzeichnet, daß** Ladeschalter (X1) und Entladeschalter (X2) gesteuerte, elektronische, nur in einer Richtung stromdurchlässige Halbleiterschalter sind.

## Claims

1. Method for driving at least one capacitive actuator (P), in particular a piezoelectrically operated fuel injection valve of an internal combustion engine,
- wherein, at the start of a driving operation, the actuator (P1 to Pn) is charged with a predefinable charging voltage (Uc = Uc1 + Uc2) via a ring-around coil (L) from a series circuit composed of a charging capacitor (C1) and a charge-reversing capacitor (C2), and discharged again into the charge-reversing capacitor (C2) at the end of the driving operation,
- wherein the actuator voltage (Upᵢₛₜ) reached at the actuator (P) by means of the charging voltage (Uc) is compared with a predefined desired voltage value (Upₛₒₗₗ),
- wherein the charging voltage (Ucₙₑᵤ) for the next driving operation is determined as a function of the difference (Upₛₒₗₗ - Upᵢₛₜ) between the predefined desired value (Upₛₒₗₗ) and the actual value (Upᵢₛₜ), and
- wherein the charging capacitor (C1) is charged for the next driving operation to a voltage (Uc1 = Ucₙₑᵤ - Uc2) corresponding to the difference (Ucₙₑᵤ - Uc2) between this specific charging voltage (Ucₙₑᵤ) and the voltage (Uc2) currently present across the charge-reversing capacitor (C2).

2. Method according to claim 1, **characterised in that** at the start of the first driving operation of each actuator (P1 to Pn) a value is predefined for the charging voltage (Ucₙₑᵤ).

3. Method according to claim 2, **characterised in that** the predefined value (Ucₙₑᵤ) for the charging voltage (Uc) is set as a function of the engine temperature.

4. Device for performing the method according to one of the preceding claims, **characterised in that**
a charging capacitor (C1) is disposed between the positive pole (Uc1) and the negative pole (GND) of a voltage source (SNT) which is controllable by a control circuit (ST),
a series circuit is disposed in parallel with said charging capacitor (C1) and comprises a charging switch (X1) connected to said positive pole (Uc1) for conducting current away from said positive pole and a discharging switch (X2) connected to said negative pole (GND) for conducting current towards said negative pole (GND),
a series circuit is disposed between the connection point of the charging switch (X1) and the discharging switch (X2) and the earth terminal (GND), said series circuit comprising a charge-reversing capacitor (C2) connected to said charging switch (X1), a ring-around coil (L), a first actuator (P1) and a first controlled Power MOSFET switch (T1),
for each further actuator a series circuit comprising said actuator (P2 to Pn) and a further Power MOSFET switch (T2 to Tn) is connected in parallel to the series circuit comprising the first actuator (P1) and the first Power MOSFET switch (T1), and
a diode (D) conducting current away from the earth terminal (GND) and towards the ring-around coil (L) is disposed in parallel with the series circuit comprising the first actuator (P1) and the first Power MOSFET switch (T1).

5. Device according to claim 4, **characterised in that** the voltage source (SNT) which is controllable by the control circuit (ST) is a switched-mode power supply.

6. Device according to claim 4, **characterised in that** the control circuit (ST) is part of a microprocessor-controlled engine control unit, that said control circuit (ST) is supplied with input variables in the form of control signals (st) for driving the actuators, the actuator voltage (Upᵢₛₜ) present at the respectively driven actuator (P1 to Pn) and the voltage (Uc2) present at the charge-reversing capacitor (C2), said control circuit further controlling the charging switch (X1), the discharging switch (X2) and the Power MOSFET switch (T1 to Tn) according to the method flowchart shown in Figure 3.

7. Device according to claim 4, **characterised in that** charging switch (X1) and discharging switch (X2) are controlled electronic semiconductor switches conducting current in one direction only.

## Revendications

1. Procédé pour exciter au moins un actionneur capacitif (P), en particulier un injecteur de carburant à commande piézoélectrique pour un moteur à combustion interne,
dans lequel, au début d'une opération d'excitation, l'actionneur (P1 à Pn) est chargé avec une tension de charge prédéterminée (Uc = Uc1 + Uc2) à travers une bobine d'oscillation (L), à partir d'un circuit série composé d'un condensateur de charge (C1) et d'un condensateur d'inversion de charge (C2), et de nouveau déchargé dans le condensateur d'inversion de charge (C2) à la fin de l'opération d'excitation,
dans lequel la tension d'actionneur (Upᵢₛₜ) qui est atteinte avec la tension de charge (Uc) sur l'actionneur (P) est comparée à une tension de consigne prédéterminée (Upₛₒₗₗ),
dans lequel la tension de charge (Ucₙₑᵤ) pour l'opération d'excitation suivante est déterminée en fonction de la différence (Upₛₒₗₗ - Upᵢₛₜ) entre la valeur de consigne (Upₛₒₗₗ) et la valeur réelle (Upᵢₛₜ), et
dans lequel le condensateur de charge (C1) est chargé, pour l'opération d'excitation suivante, à une tension de charge (Uc1 = Ucₙₑᵤ - Uc2) qui correspond à la différence (Ucₙₑᵤ - Uc2) entre cette tension de charge déterminée (Ucₙₑᵤ) et la tension (Uc2) qui est présente momentanément au condensateur d'inversion de charge (C2).

2. Procédé selon la revendication 1, **caractérisé en ce qu'**au début du fonctionnement pour la première opération d'excitation de chaque actionneur (P1 à Pn), une valeur est prédéterminée pour la tension de charge (Ucₙₑᵤ).

3. Procédé selon la revendication 2, **caractérisé en ce que** la valeur prédéterminée (Ucₙₑᵤ) pour la tension de charge (Uc) est fonction de la température (T) du moteur.

4. Dispositif pour la mise en oeuvre du procédé selon une des revendications précédentes, **caractérisé**
**en ce qu'**un condensateur de charge (C1) est disposé entre le pôle Plus (Uc1) et le pôle Moins (GND) d'une source de tension (SNT) pouvant être commandée par un circuit de commande (ST),
**en ce que**, en parallèle avec le condensateur de charge (C1), est disposé un circuit série composé d'un interrupteur de charge (X1) relié au pôle Plus (Uc1), qui laisse passer le courant en provenance de ce pôle, et un interrupteur de décharge (X2) relié au pôle Moins (GND), qui laisse passer le courant en direction de ce pôle,
**en ce que**, entre le point de jonction entre l'interrupteur de charge (X1) et l'interrupteur de décharge (X2) et la connexion de masse (GND), est disposé un circuit série composé d'un condensateur d'inversion de charge (C2) relié à l'interrupteur de charge (X1), d'une bobine d'oscillation (L), d'un premier actionneur (P1) et d'un premier interrupteur Power-MOSFET commandé (T1 ),
**en ce que**, pour chaque autre actionneur, un circuit série composé de cet actionneur (P2 à Pn) et d'un autre interrupteur Power-MOSFET (T2 à Tn) est connecté en parallèle avec le circuit série composé du premier actionneur (P1) et du premier interrupteur Power-MOSFET (T1) et
**en ce qu'**une diode (D) qui laisse passer le courant de la connexion de masse (GND) à la bobine d'oscillation (L) est connectée en parallèle avec le circuit série composé du premier actionneur (P1) et de l'interrupteur Power-MOSFET (T1).

5. Dispositif selon la revendication 4, **caractérisé en ce que** la source de tension (SNT) qui peut être commandée par le circuit de commande (ST) est une partie du circuit de réseau.

6. Dispositif selon la revendication 4, **caractérisé en ce que** le circuit de commande (ST) fait partie d'un appareil de commande de moteur commandé par microprocesseur, **en ce que**, au circuit de commande (ST) sont appliqués, comme grandeurs d'entrée, des signaux de commande (st) destinés à exciter les actionneurs, la tension d'actionneur (Upᵢₛₜ) appliquée à l'actionneur (P1 à Pn) qui est excité au moment considéré, et la tension (Uc2) appliquée au condensateur d'inversion de charge (C2), et qui commande l'interrupteur de charge (X1), l'interrupteur de décharge (X2) et les interrupteurs Power-MOSFET (T1 à Tn) conformément à l'organigramme selon la figure 3.

7. Dispositif selon la revendication 4, **caractérisé en ce que** l'interrupteur de charge (X1) et l'interrupteur de décharge (X2) sont des interrupteurs à semiconducteur commandés, électroniques, qui ne laissent passer le courant que dans un sens.
